## Europäisches Patentamt
## European Patent Office
## Office européen des brevets

(19)

(11) Veröffentlichungsnummer: **0 219 641**
**B1**

(12) **EUROPÄISCHE PATENTSCHRIFT**

(45) Veröffentlichungstag der Patentschrift: **09.01.91**

(51) Int. Cl.⁵: **H 01 L 27/06, H 01 L 21/82, H 01 L 21/60**

(21) Anmeldenummer: **86111444.5**

(22) Anmeldetag: **19.08.86**

(54) **Integrierte Bipolar- und komplementäre MOS-Transistoren auf einem gemeinsamen Substrat enthaltende Schaltung und Verfahren zu ihrer Herstellung.**

(30) Priorität: **13.09.85 DE 3532817**

(43) Veröffentlichungstag der Anmeldung:
**29.04.87 Patentblatt 87/18**

(45) Bekanntmachung des Hinweises auf die
Patenterteilung:
**09.01.91 Patentblatt 91/02**

(84) Benannte Vertragsstaaten:
**AT DE FR GB IT SE**

(56) Entgegenhaltungen:
**EP-A-0 051 500**
**EP-A-0 101 000**
**EP-A-0 139 266**
**US-A-4 256 515**

**IBM TECHNICAL DISCLOSURE BULLETIN, Band 24, Nr. 11A, April 1982, Seiten 5571-5573, New York, US; A.W. CHANG et al.: "bifet process and technology"**

(73) Patentinhaber: **Siemens Aktiengesellschaft**
**Wittelsbacherplatz 2**
**D-8000 München 2 (DE)**

(72) Erfinder: **Neppl, Franz, Dr.**
**St.-Quirin-Platz 6**
**D-8000 München 90 (DE)**
Erfinder: **Winnerl, Josef, Dr.**
**Schubert-Strasse 2**
**D-8300 Landshut (DE)**

(56) References cited:
**EXTENDED ABSTRACTS, Band 82-2, Oktober 1982, Seiten 305-306, Zusammenfassung Nr. 193, Pennington, New York, US; R.H. VOGEL et al.: "Electrical properties of 200-500A LPCVD SiO2 films"**

**IEEE TRANSACTIONS ON ELECTRON DEVICES, Band ED-27, Nr. 8, August 1980, Seiten 1409-1417, IEEE, New york, US; S.P. MURARKA et al.: "Refractory silicides of titanium and tantalum for low-resistivity gates and interconnects"**

**Beschreibung**

Die Erfindung betrifft eine integrierte Bipolar- und komplementäre MOS (= CMOS)-Transistoren auf einem gemeinsamen Substrat enthaltende Schaltung, bei der die Emitteranschlüsse der Bipolar-Transistoren sowie die Gate-Elektroden der MOS-Transistoren aus dem gleichen Material und mindestens aus einer Schicht eines Silizids eines hochschmelzenden Metalles wie Tantal, Wolfram, Molybdän, Titan oder Platin bestehen, sowie ein Verfahren zu ihrer Herstellung.

Eine integrierte Schaltung, bei der ein Bipolar-Transistor und ein MOS-Transistor auf einem Chip erzeugt werden und bei der die Kontakte aus der Metall-Leiterbahnebene zu den diffundierten Bereichen des Bipolar-Transistors und die Gate-Elektrode aus dem gleichen Material und aus einem Silizid eines hochschmelzenden Metalles bestehen, ist aus der europäischen Patentanmeldung 0 101 000 bekannt. Durch die Verwendung des Silizids wird nicht nur gegenüber den herkömmlichen Verfahren eine Implantationsmaske eingespart, sondern es wird auch eine Unabhängigkeit vom Metallisierungsraster bei der Kontaktierung von Basis-, Emitter- und Kollektorgebieten erreicht.

Aus der EP—A—0 139 266 ist eine integrierte Schaltung bekannt, in der ein Bipolarer und ein CMOS Transistor auf einem gemeinsamen Substrat angeordnet sind. Der Emitteranschluß sowie die Gate-Elektroden der MOS Transistoren sind aus dem gleichen Material. Die Emitter — Basis — anschlüsse sind selbstjustierend zueinander angeordnet. Der Basisanschluß ist jedoch zu dem Emitter fremdjustiert.

Sollen auf einem Chip gleichzeitig Bipolar-Transistoren und komplementäre MOS (= CMOS)-Transistoren hergestellt werden, so wird von einem n-Wannen-CMOS-Prozeß ausgegangen und die Emittergebiete und die Basisanschlüsse der Bipolar-Transistoren werden gleichzeitig mit den Source- und Drain-Gebieten der MOS-Transistoren implantiert und mit Metall kontaktiert. Ein solcher Prozeß ist beispielsweise in der deutschen Patentanmeldung P 35 19 790.0 die der Art. 54(3) EP—A—0 204 973 entspricht, vorgeschlagen worden. Bei diesem Prozeß werden in die n-dotierten Wannen npn-Bipolar-Transistoren gelegt, wobei die n-Wanne den Kollektor des Transistors bildet und vergrabene n$^+$-dotierte Zonen bedeckt, die im Bipolar Transistorbereich durch tiefreichende Kollektoranschlüsse angeschlossen werden. Der vergrabene Teil und der Kollektoranschluß wird bei diesem Prozeß vor der Wanne erzeugt. Die Wannenimplantation ist selbstjustierend zur Implantation des ringförmig in die Wanne gelegten tiefen Kollektoranschlusses. Dadurch ergibt sich eine Verringerung des Kollektorbahnwiderstandes, sowie eine erhöhte Latch-up-Festigkeit.

Durch die Prozeßfolge und bedingt durch die Metallkontaktierung ergeben sich aber folgende Nachteile:

1. Die Transistorgröße ist durch das Metallisierungsraster begrenzt.

2. Der Abstand von Emitter zu Basiskontakt ist justierabhängig.

3. Es ist nur mit einem zusätzlichen Photolithographieschritt möglich, unterschiedliche Dotierstoffe zur Erzeugung der Emitterzonen der Bipolar-Transistoren und der Source/Drain-Zonen der n-Kanal-MOS-Transistoren im Substrat zu verwenden.

Die Aufgabe die der Erfindung zugrundeliegt, besteht in der Schaffung einer integrierten CMOS-Transistoren und Bipolar-Transistoren auf einem Chip enthaltenden Schaltung, bei der neben einer weiteren Erhöhung der Packungsdichte die Vorteile der Silizid- bzw. Polyzid (= Doppelschicht aus Polysilizium und Silizid)-Verdrahtung mit den Vorteilen eines tiefreichenden Kollektoranschlusses bei den Bipolar-Transistoren kombiniert sind.

Weiterhin ist es Aufgabe der Erfindung, ein Verfahren anzugeben, das die Herstellung dieser integrierten Halbleiterschaltung in möglichst einfachen, maskensparenden Prozeßschritten erlaubt, wobei die Möglichkeit gegeben ist, die Emitter der Bipolar-Transistoren unabhängig von der Erzeugung der Source/Drain-Zonen der n-Kanal-MOS-Transistoren zu dotieren.

Die Erfindung betrifft eine integrierte Schaltung der eingangs genannten Art, die gekennzeichnet ist durch folgende Merkmale:

a) der Ermitteranschluß und der Ermitter sind selbstjustierend zu dem Basisanschluß angeordnet,

b) zumindest der Emitteranschluß besteht aus einem dotierten Silizid oder aus einer dotierten Doppelschicht aus Polysilizium und Silizid,

c) der Kollektor ist im Substrat als vergrabene Zone enthalten und

d) der Kollektoranschluß ist ringförmig um den Bipolar-transistor ausgebildet.

Die Erfindung betrifft außerdem ein Verfahren, welches gekennzeichnet ist durch den Ablauf der folgenden Verfahrensschritte:

a) Herstellen der vergrabenen n$^+$-dotierten Zonen im p-dotierten Substrat durch Implantation von n-dotierenden Ionen nach vorheriger Maskierung der übrigen Bereiche,

b) ganzflächiges Aufbringen einer p-dotierten Epitaxie-Schicht,

c) Erzeugung einer ganzflächigen Isolations-Doppelschicht aus Siliziumoxid und Siliziumnitrid,

d) Festlegung der Bereiche für den tiefreichenden Kollektoranschluß durch eine Tiefimplantation mit n-dotierenden Ionen nach vorheriger Strukturierung der Siliziumnitridschicht durch Photolithographie,

e) Erzeugen der n-Wannen im Substrat durch Implantation von n-dotierenden Ionen nach Ablösen der Siliziumnitridstrukturen über den n-Wannenbereichen,

f) Eindiffusion der implantierten, n-dotierenden Ionen in das Substrat und gleichzeitige Oxidation der Oberfläche in den n-Wannenbereichen,

g) Durchführung einer Tiefimplantation von Bor-Ionen zur Herstellung des oberflächenfernen Bereichs der Kanalzone der n-Transistoren nach Entfernung der Siliziumnitridstrukturen, wobei das Oxid als Maske wirkt,

h) Aufbringen einer aus Siliziumoxid und Siliziumnitrid bestehenden Doppelschicht und entsprechende Strukturierung der Siliziumnitridschicht für die nachfolgende lokale Oxidation,

i) Durchführung einer Bor-Ionenimplantation zur Dotierung der Feldoxidbereiche der n-Kanal-Transistoren nach vorheriger Photolackmaskierung der übrigen Bereiche,

j) Herstellung des für die Trennung der aktiven Transistorbereich im Substrat erforderlichen Feldoxids durch lokale Oxidation nach Entfernung der Photolackmaske und unter Verwendung der Siliziumnitrid-Struktur als Oxidationsmaske,

k) ganzflächige Oxidation zur Erzeugung des Gateoxids nach Entfernung der Siliziumnitridstruktur,

l) Durchführung einer ganzflächigen, flachen Bor-Ionen implantation zur Dotierung der Kanalbereiche der n- und p-Kanal-MOS-Transistoren,

m) Herstellung der Basiszone im Bipolar-Transistorbereich durch Bor-Ionenimplantation nach vorheriger Photolackmaskierung der übrigen Bereiche,

n) Entfernung des Gateoxids im Bereich der Basiszone,

o) ganzflächige Abscheidung von Metallsilizid oder einer Doppelschicht aus Polysilizium und Metallsilizid,

p) Abscheidung einer ganzflächigen Oxidschicht und Arsen-Ionenimplantation,

q) Strukturierung der Metallsilizid oder Polyzid-Doppelschicht zur Herstellung der Gate-Elektroden der MOS-Transistoren und der Emitteranschlüsse der Bipolar-Transistoren,

r) Durchführung einer Hochtemperaturbehandlung zur Erzeugung der Emitterzone,

s) Abscheidung einer ganzflächigen, als Zwischenoxid wirkenden Siliziumoxidschicht aus der Gasphase,

t) gleichzeitige Herstellung der Source/Drain-Bereiche der n-Kanal-Transistoren und des n⁺-Kollektorkontaktes der Bipolar-Transistoren durch Phosphor-Ionenimplantation nach vorheriger Photolackmaskierung der p-Kanal-Transistor-Bereiche und der Bipolar-Transistorbereiche mit Ausnahme des n⁺-Kollektorbereichs,

u) gleichzeitige Herstellung der Source/Drain-Bereiche der p-Kanal-Transistoren und des p⁺-Basiskontaktes der Bipolar-Transistoren durch Bor-Ionenimplantation nach vorheriger Photolackmaskierung der n-Kanal-Transistorbereiche und der Bipolar-Transistorbereiche mit Ausnahme des p⁺-Basisbereiches,

v) Entfernung der Photolackmaske, Freilegung der Kontaktlochbereiche, Durchführung der Metallisierung zur Herstellung der Anschlußelektroden und Passivierung in bekannter Weise.

Weitere Ausgestaltungen der Erfindung ergeben sich aus den Unteransprüchen.

Gegenüber dem in der EP—A—0 204 979 vorgeschlagenen Verfahren weist das erfindungsgemäße Verfahren folgende Vorteile auf:

1. Das dotierte Gateelektrodenmaterial der MOS-Transistoren dient gleichzeitig als Diffusionsquelle und als Anschluß für die Emitter der Bipolar-Transistoren. Außerdem dient dieser Emitteranschluß als Maske für die Basisanschluß-Implantation. Dadurch wird der Abstand von Emitter zu Basiskontakt justierunabhängig und nur durch das Trennoxid (spacer) definiert. Der Basisbahnwiderstand wird klein gehalten.

2. Der Emitter wird nicht implantiert, sondern diffundiert, das heißt, die Dotierung von Bipolar-Emitter und n-Kanal-Source/Drain erfolgt unabhängig voneinander. So kann der Emitter zur Erzielung eines flacheren pn-Überganges mit Arsen dotiert und die Source/Drain-Zonen zur Verbesserung der Spannungsfestigkeit mit Phosphor dotiert werden, ohne daß dafür ein zusätzlicher Photolithographieschritt erforderlich wird.

3. Durch die Verwendung von Metallsilizid oder Polyzid als Emitteranschluß ist dieser unabhängig vom Metallisierungsraster, was eine Erhöhung der Packungsdichte der Schaltung bedeutet. Außerdem wird bei Verwendung von Polyzid der Emitterwirkungsgrad erhöht.

4. Die Emitterbreite ist nicht durch die Kontaktlochgröße begrenzt.

Gegenüber dem in der europäischen Patentanmeldung 0 101 000 beschriebenen Verfahren weist das erfindungsgemäße Verfahren den Vorteil der gleichzeitigen Herstellung von komplementären MOS (CMOS)-Transistoren mit in den n-Wannen erzeugten Bipolar-Transistorstrukturen mit vergräbenen n⁺-dotierten Zonen und ringförmig in die Wannen gelegten tiefen Kollektoranschlüssen auf, die eine Veringerung des Kollektorbahnwiderstandes, sowie eine erhöhte Latch-up-Festigkeit der Schaltung zur Folge haben. Außerdem ist der Abstand von Emitter und Basisanschluß justierunabhängig.

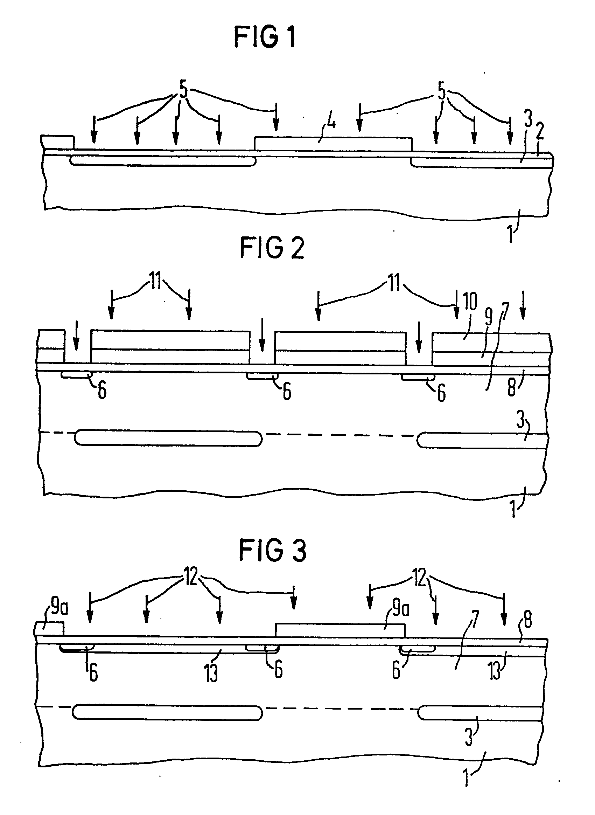

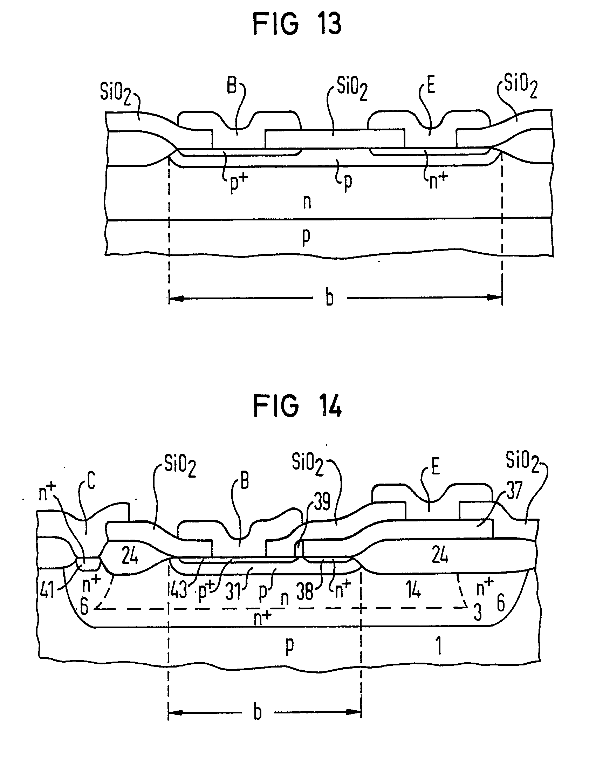

Im folgenden wird anhand der Figuren 1 bis 14 und eines Ausführungsbeispiels der Prozeßablauf für die gleichzeitige Herstellung von bipolaren und komplementären MOS (CMOS)-Transistoren auf einem gemeinsamen Substrat (Chip) noch näher beschrieben. Dabei sind in den Figuren 1 bis 12 im Schnittbild die Verfahrensschritte zusammengefaßt dargestellt; für gleiche Teile sind gleiche Bezugszeichen vorgesehen. Die Figuren 13 und 14 zeigen den relativen Größenvergleich des Basis-Emitter-Komplexes eines npn-Transistors nach einem bekannten Verfahren hergestellt (Figur 13) und nach dem erfindungsgemäßen Verfahren (Figur 14).

*Figur 1:* Auf einer einkristallinen p-dotierten, (100)-orientierten Siliziumscheibe 1 mit einem spezifischen Widerstand von 20 Ohm cm und einer SiO₂-Schicht 2 wird zunächst der vergrabene Kollektorbereich 3 dadurch erzeugt, daß nach erfolgter Photolackmaskierung 4 eine Antimon- oder Arsen-Ionenimplantation 5 mit einer Dosis und Energie von $3 \times 10^{15}$ cm⁻² und 80 keV durchgeführt wird.

*Figur 2:* Die Bereiche für den tiefen Kollektoranschluß 6 werden dadurch hergestellt, daß auf die in Figur 1 dargestellte Anordnung nach Entfernung der $SiO_2$-Schicht 2 eine 3 µm-dicke $p^-$-dotierte Epitaxieschicht 7 mit einem spezifischen elektrischen Widerstand von 20 Ohm cm abgeschieden wird, die Epitaxieschicht 7 mit einer isolierenden Doppelschicht, bestehend aus einer 50 nm dicken $SiO_2$-Schicht 8 und einer 140 nm dicken CVD-Siliziumnitridschicht 9 bedeckt wird. Durch die Photolacktechnik 10 wird die Nitridschicht 9 strukturiert und anschließend die Kollektortiefimplantation 11 mit Phosphor-Ionen bei einer Dosis und Energie von $3 \times 10^{15}$ cm$^{-2}$ und 80 keV durchgeführt.

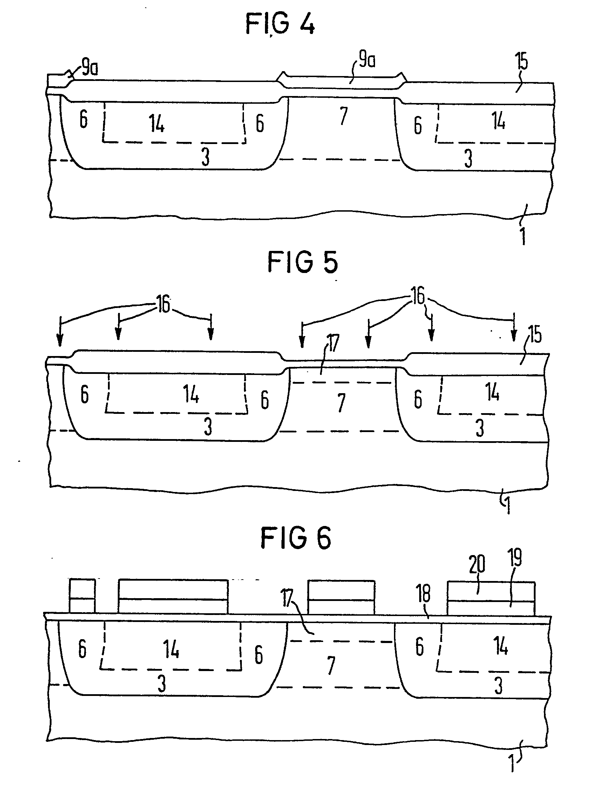

Figur 3 zeigt die Erzeugung der n-Wannenbereiche (14 in Figur 4) durch eine Phosphor-Ionenimplantation 12 mit einer Dosis und Energie von $2 \times 10^{12}$ cm$^{-2}$ und 180 keV nach erfolgter Photolacktechnik (nicht dargestellt) und Entfernung der Nitridstrukturen über den n-Wannenbereichen (14). Es bleibt die Nitridstrukturierung 9a und es entstehen die implantierten Bereiche 13.

Figur 4: Nun erfolgt die Oxidation zur Maskierung der n-Wannenbereiche (14) und gleichzeitig die Eindiffusion der Antimon- und Phosphor-Ionen, das heißt der drive-in von n-Warne 14 und Kollektoranschluß 6. Auf der Oberfläche entsteht eine $SiO_2$-Schicht 15, wobei die Nitridmaske 9a als Maskierung dient. Bei dieser Temperaturbehandlung (1150°C) wird der Kollektoranschluß 6 ca. 3 µm in das Substrat 1 eingetrieben, so daß der vergrabene Kollektorbereich 3 sicher erreicht wird.

Figur 5: Die erste tiefe Implantation der Doppel-Kanalimplantation der n-Kanal-Transistoren erfolgt nach Entfernung der Siliziumnitridstruktur 9a durch ganzflächige Tiefimplantation 16 mit Bor-Ionen bei einer Dosis und Energie von $8 \times 10^{11}$ cm$^{-2}$ und 60 keV, wobei die $SiO_2$-Schicht 15 als Maske wirkt. Es entsteht der p-dotierte Bereich 17 unter dem Kanal.

Figur 6: Es folgt die Erzeugung einer aus thermischem $SiO_2$ (50 nm) und abgeschiedenem Siliziumnitrid (140 nm) bestehenden Doppelschicht 18, 19 und entsprechende Strukturierung der Siliziumnitridschicht 19 mit der Photolacktechnik 20 als Maskierung für die später nachfolgende lokale Oxidation (LOCOS).

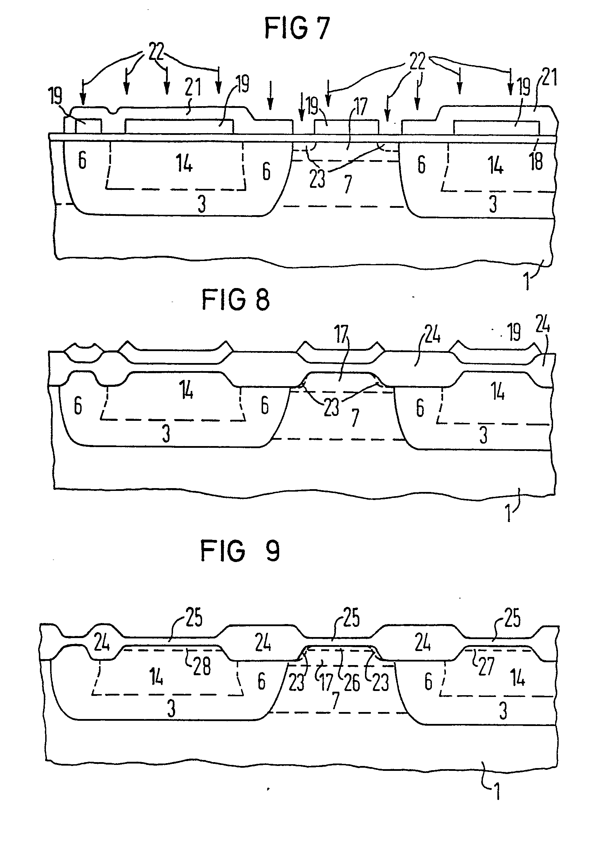

Figur 7: Zur Erzeugung der Felddotierung im n-Kanalbereich wird nach erneuter Photolacktechnik 21 eine Bor-Ionenimplantation 22 mit einer Dosis und Energie von $1,2 \times 10^{13}$ cm$^{-2}$ und 25 keV durchgeführt. Es entstehen die p-dotierten Bereiche 23.

Figure 8: Nun wird das für die Trennung der aktiven Transistorbereiche im Substrat 1 erforderliche Feldoxid 24 durch lokale Oxidation unter Verwendung der Siliziumnitridmaskierung 19 nach Entfernung der Photolackmaske 21 auf der $SiO_2$-Schicht 18 in einer Schichtdicke von 850 nm erzeugt. Die beiden Oxidschichten werden ab jetzt mit dem Bezugszeichen 24 bezeichnet.

Bis hierher sind die Prozeßschritte identisch mit den in Figur 1 bis 8 dargestellten Prozeßschritten der deutschen Patentanmeldung P 35 19 790.0 (= EP—A—0 204 979).

Figur 9: Nach Entfernung der Siliziumnitridstrukturen 19 erfolgt nun die Gateoxidation mit einer Schichtdicke des Gateoxids 25 von 25 nm. Wenn als Emitteranschluß- und Gatematerial Polyzid verwendet werden soll, empfiehlt es sich, an dieser Stelle wegen der erhöhten Kanaldotierung eine tiefe und eine flache Kanalimplantation mit Bor-Ionen durchzuführen (nicht dargestellt), wobei die flache Implantation ganzflächig mit einer Dosis und Energie von $2 \times 10^{11}$ cm$^{-2}$ und 25 keV und die tiefe Implantation mit Phototecknik nur im n-Kanalbereich der MOS-Transistoren mit einer Dosis und Energie von $8 \cdot 10^{11}$ cm$^{-2}$ und 60 keV durchgeführt wird. Es entstehen die Kanalbereiche 26 und 27 und der p-Bereich 28 in der Basis der Bipolartransistors.

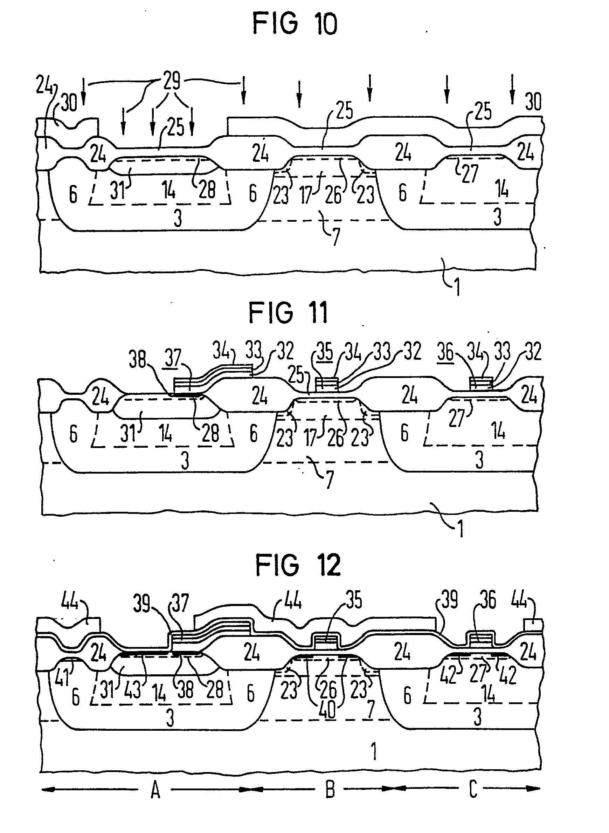

Figur 10: Nun erfolgt die Basisimplantation 29 des Bipolartransistors nach vorheriger Photolackmaskierung 30 mit Bor-Ionen mit einer Dosis und Energie von $9 \times 10^{13}$ cm$^{-2}$ und 80 keV. Es entsteht die p-dotierte Basiszone 31. Im Bereich der Basiszone 28, 31 wird die Gateoxidschicht 25 entfernt.

Figur 11: Die Gate-Elektroden der MOS-Transistoren (35, 36) und der Emitteranschluß (37) des Bipolar-Transistors werden dadurch erzeugt, daß nach Entfernung der Photolackstrukturen 30 eine ganzflächige Abscheidung einer dotierten Doppelschicht, bestehend aus einer Polysiliziumschicht 32 und einer Tantalsilizidschicht 33 durchgeführt wird und anschließend die Elektroden und der Emitteranschluß mit einer darauf abgeschiedenen Oxidschicht 34 mittels Photolacktechnik (in der Figur nicht dargestellt) strukturiert werden. Anstelle der Doppelschicht 32, 33 kann auch eine einfach dotierte Tantalsilizidschicht 33 verwendet werden. Nach einer Temperaturbehandlung bei 900°C entsteht unter dem Emitteranschluß die Emitterzone 38.

Figur 12: Dann wird das Zwischenoxid 39 an Form einer konformen TEOS-Spacer-Schicht durch ganzflächige Abscheidung von $SiO_2$ aus der Gasphase durch thermische Zersetzung von Tetraethylorthosilikat (= TEOS) in einer Schichtdicke von 100 nm erzeugt. Anschließend erfolgt die gleichzeitige Herstellung der Source/Drain-Bereiche 40 der n-Kanal-Transistoren B und des $n^+$-Kollektorkontaktbereiches 41 der Bipolar-Transistoren A durch Phosphorionenimplantation bei einer Dosis und Energie von $8 \times 10^{15}$ cm$^{-2}$ und 80 keV nach vorheriger Photolackmaskierung der übrigen Bereiche (p-Kanal-Transistoren, Bipolar-Transistorbereich A mit Ausnahme des Kollektorkontaktbereiches 41). Dieser Vorgang ist im einzelnen nicht dargestellt.

In analoger Weise wie eben beschrieben werden die Source/Drain-Bereiche 42 der p-Kanal-Transistoren C und der $p^+$-Basiskontaktbereich 43 des Bipolar-Transistors A durch eine Bor-Ionenimplantation mit einer Dosis und Energie von $4 \times 10^{15}$ cm$^{-2}$ und 40 keV erzeugt. Dabei werden die n-Kanaltransistorbereiche B und der Kollektoranschlußbereich 41 des Bipolar-Transistors A mit einer Photolackmaske 44 abgedeckt. Der Emitteranschluß 37 dient dabei als Implantationsmaske. Der Abstand Emitter-/Basis-Anschluß (38, 43) ist durch das Spaceroxid 39 definiert. Dies ist ein wesentlicher Punkt der Erfindung und trägt zur Erhöhung der Packungsdichte bei. Außerdem wird, wie bereits berichtet, dadurch der Basisbahnwiderstand sehr klein gehalten und die parasitären Kapazitäten werden verringert.

Die Fertigstellung der Schaltungsanordnung erfolgt in bekannter Weise durch Kontaktlochtechnik, Metallisierung (Einlagen- oder Zweilagen-Metallisierung) und Passivierung.

Die unter der Figur eingezeichneten Buchstaben (A, B und C) markieren den Bereich des Bipolar-Transistors A und die Bereiche des n-Kanal-Transistors B sowie des p-Kanal Transistors C.

In einer Version des erfindungsgmäßen Verfahrens ist es auch möglich, von einem p-dotierten Substrat mit einem spezifischen elektrischen Widerstand von 0,02 Ohm cm auszugehen und die in Figur 1 dargestellte Implantation zur Erzeugung des vergrabenen Kollektors wegzulassen oder bei einem Ausgangsmaterial von 20 Ohm cm die in Figur 1 dargestellte Implantation wegzulassen und die in Figur 3 dargestellte Epitaxieschicht nicht aufzubringen. Durch die Einsparung des vergrabenen Kollektors ergibt sich eine Prozeßvereinfachung, wobei der ringförmige Kollektoranschluß gegenüber herkömmlichen Prozessen ohne vergrabenen Kollektor eine Verbesserung im Kollektorwiderstand und der Latch-up-Festigkeit ergibt.

Desweiteren kann auch bei der Gateelektroden- und Emitteranschluß-Erzeugung die Reihenfolge der Abscheidung von Polysilizium und Metallsilizid getauscht werden oder die Dotierung nicht durch Ionenimplantation, sondern bereits bei der Gasphasenabscheidung erfolgen.

Aus den Figuren 13 und 14 ist ein relativer Größenvergleich des Basis (B)-Emitter (E)-Komplexes eines npn-Transistors nach einem herkömmlichen Prozeß (Figur 13) und nach dem erfindungsgemäßen Verfahren (Figur 4) ersichtlich. Mit den Buchstaben "b" ist die minimale Basisbreite eingezeichnet. Ansonsten wurden in Figur 14 nur die wichtigsten Bezugszeichen aus Figur 12 übernommen; das Isolationsoxid wurde mit dem Symbol "SiO$_2$" versehen. Außerdem wurden in beiden Figuren die Dotierungen eingezeichnet.

Bezugszeichenliste
1 Siliziumsubstrat
2 SiO$_2$-Schicht
3 vergrabener Collektorbereich
4 Photolack
5 Arsen-Ionenimplantation
6 Kollektoranschluß
7 p-dot. Epitaxieschicht
8 SiO$_2$-Schicht
9 Siliziumnitridschicht
10 Photolack
11 Kollektortiefimplantation
12 Phosphor-Ionenimplantation
13 Phosphor implantierte Bereiche
14 n-Wanne

15 SiO$_2$-Schicht
16 Bor-Ionenimplantation
17 p-dotierter Bereich
18 SiO$_2$-Schicht
19 Siliziumnitridschicht
20 Photolack
21 Photolack
22 Bor-Ionenimplantation
24 Feldoxid
25 Gateoxid
26 Kanalbereich
27 Kanalbereich
28 Basisbereich
29 Basisimplantation
30 Photolack
31 p-dotierte Bereiche
32 Polysiliziumschicht
33 Tantalsilizidschicht
34 Oxidschicht
35 Gate-Elektrode
36 Gate-Elektrode
37 Emitteranschluß
38 Emitterzone
39 Zwischenoxid/Spaceroxid
40 Source/Drain-Bereiche (n-Kanal)
41 Kollektorkontaktbereich
42 Source/Drain-Bereiche (p-Kanal)
43 Basiskontakt
44 Photolack

**Patentansprüche**

1. Integrierte Bipolar (A)- und komplementäre MOS-Transistoren (B, C) auf einem gemeinsamen Substrat (1) enthaltende Schaltung, bei der die Emitteranschlüsse (37) der Bipolar-Transistoren (A) sowie die Gate-Elektroden (35, 36) der MOS-Transistoren (B, C) aus dem gleichen Material und mindestens aus einer Schicht eines Silizids eines hochschmelzenden Metalles wie Tantal, Wolfram, Molybdän, Titan oder Platin bestehen, dadurch gekennzeichnet, daß

a) der Emitteranschluß (37) und der Emitter (38) selbstjustierend zu dem Basisanschluß (43) angeordnet sind,

b) zumindest der Emitteranschluß (37) aus einem dotierten Silizid oder aus einer dotierten Doppelschicht aus Polysilizium und Silizid besteht,

c) der Kollektor als vergrabene Zone (3) im Substrat (1) enthalten ist, und

d) der Kollektoranschluß (6) ringförmig um den Bipolar-Transistor (A) ausgebildet ist.

2. Integrierte Halbleiterschaltung nach Anspruch 1, dadurch gekennzeichnet, daß der Emitteranschluß (37) mit Arsen dotiert ist und aus Tantalsilizid (33) oder Polysilizium (32) und Tantalsilizid (33) besteht.

3. Verfahren zum Herstellen einer Bipolar (A)- und MOS-Transistoren (B, C) enthaltenden integrierten Halbleiterschaltung nach Anspruch 1 und/oder 2, in dem folgende Verfahrensschritte ablaufen:

a) Herstellen der vergrabenen n$^+$-dotierten Zonen (3) im p-dotierten Substrat (1) durch Implantation (5) von n-dotierenden Ionen nach vorheriger Maskierung (4) der übrigen Bereiche,

b) ganzflächiges Aufbringen einer p-dotierten Epitaxie-Schicht (7),

c) Erzeugung einer ganzflächigen Isolations-Doppelschicht aus Siliziumoxid (8) und Siliziumnitrid (9),

d) Festlegung der Bereiche für den tiefreichenden Kollektoranschluß (6) durch eine Tiefimplantation (11) mit n-dotierenden Ionen nach vorheriger Strukturierung der Siliziumnitridschicht (9) durch Photolithographie (10),

e) Erzeugen der n-Wannen (14) im Substrat (1) durch Implantation (12) von n-dotierenden Ionen nach Ablösen der Siliziumnitridstrukturen über den n-Wannenbereichen (14),

f) Eindiffusion der implantierten, n-dotierenden Ionen in das Substrat (1) und gleichzeitige Oxidation (15) der Oberfläche in den n-Wannenbereichen (14),

g) Durchführung einer Tiefimplantation (16) von Bor-Ionen zur Herstellung eines oberflächenfernen Bereiches der Kanalzone (17) der n-Transistoren (B) nach Entfernung der Siliziumnitridstrukturen (9a), wobei das Oxid (15) als Maske wirkt,

h) Aufbringen einer aus Siliziumoxid (18) und Siliziumnitrid (19) bestehenden Doppelschicht und entsprechende Strukturierung der Siliziumnitridschicht (19) für die nachfolgende lokale Oxidation (LOCOS),

i) Durchführung einer Bor-Ionenimplantation (22) zur Dotierung der Feldoxidbereiche (23) der n-Kanal-Transistoren nach vorheriger Photolackmaskierung (21) der übrigen Bereiche,

j) Herstellung des für die Trennung der aktiven Transistorbereiche (A, B, C) im Substrat (1) erforderlichen Feldoxids (24) durch lokale Oxidation nach Entfernung der Photolackmaske (21) und unter Verwendung der Siliziumnitrid-Struktur (19) als Oxidationsmaske,

k) ganzflächige Oxidation zur Erzeugung des Gateoxids (25) nach Entfernung der Siliziumnitridstrukturen (19),

l) Durchführung einer ganzflächigen, flachen Bor-Implantation zur Dotierung der Kanalbereiche (26, 27) der n- und p-Kanal-MOS-Transistoren,

m) Herstellung der Basiszone (31) im Bipolar-Transistorbereich (A) durch Bor-Ionenimplantation (29) nach vorheriger Photolackmaskierung (30) der übrigen Bereiche,

n) Entfernung des Gateoxids (25) im Bereich der Basiszone (31),

o) ganzflächige Abscheidung von Metallsilizid (33) oder einer Doppelschicht aus Polysilizium (32) und Metallsilizid (33),

p) Abscheidung einer ganzflächigen Oxidschicht (34) und Arsen-Ionenimplantation,

q) Strukturierung der Metallsilizidschicht (33) oder der Polyzid-Doppelschicht (32, 33) zur Herstellung der Gate-Elektroden (35, 36) der MOS-Transistoren (B, C) und der Emitteranschlüsse (37) der Bipolar-Transistoren (A),

r) Durchführung einer Hochtemperaturbehandlung zur Erzeugung der Emitterzone (38),

s) Abscheidung einer ganzflächigen, als Zwischenoxid wirkenden Siliziumoxidschicht (39) aus der Gasphase,

t) gleichzeitige Herstellung der Source/Drain-Bereiche (40) der n-Kanal-Transistoren (B) und des $n^+$-Kollektorkontaktes (41) der Bipolar-Transistoren (A) durch Phosphor-Ionenimplantation nach vorheriger Photolackmaskierung der p-Kanal-Transistor bereiche (C) und der Bipolar-Transistorbereiche (A) mit Ausnahme des $n^+$-Kollektorbereiches (41),

u) gleichzeitige Herstellung der Source/Drain-Bereiche (42) der p-Kanal-Transistoren (C) und des $p^+$-Basiskontaktes (43) der Bipolar-Transistoren (A) durch Bor-Ionenimplantation nach vorheriger Photolackmaskierung (44) der n-Kanal-Transistorbereiche (B) und der Bipolar-Transistorbereiche (A) mit Ausnahme der $p^+$-Basisbereiches (43),

v) Entfernung der Photolackmaske (44), Freilegung der Kontaktlochbereiche, Durchführung der Metallisierung zur Herstellung der Anschlußelektroden und Passivierung in bekannter Weise.

4. Verfahren nach Anspruch 3, dadurch gekennzeichnet, daß zwischen Verfahrensschritt k) und l) nach vorheriger Phototechnik eine Bor-Ionenimplantation im Bereich der n-Kanal-MOS-Transistoren (B) durchgeführt wird.

5. Verfahren nach Anspruch 3 und 4, dadurch gekennzeichnet, daß ein p-dotiertes (100)-orientiertes Siliziumsubstrat (1) mit einem spezifischen elektrischen Widerstand von 20 Ohm cm verwendet wird.

6. Verfahren nach Anspruch 3 und 4, dadurch gekennzeichnet, daß ein p-dotiertes, (100)-orientiertes Siliziumsubstrat (1) mit einem spezifischen elektrischen Widerstand von 0,02 Ohm cm verwendet wird, und daß der Verfahrensschritt a) entfällt.

7. Verfahren nach mindestens einem der Ansprüche 3 bis 5, dadurch gekennzeichnet, daß die Verfahrensschritte a) und b) entfallen.

8. Verfahren nach mindestens einem der Ansprüche 3 bis 7, dadurch gekennzeichnet, daß der spezifische elektrische Widerstand der p-dotierten Epitaxieschicht (7) nach Verfahrensschritt b) auf 20 Ohm cm und die Schichtdicke auf ca. 3 µm eingestellt wird.

9. Verfahren nach mindestens einem der Ansprüche 3 bis 8, dadurch gekennzeichnet, daß die Herstellung der Zwischenoxidschicht (39) nach Verfahrensschritt s) durch thermische Zersetzung von Tetraethylorthosilikat (= TEOS) erfolgt.

10. Verfahren nach mindestens einem der Ansprüche 3 bis 9, dadurch gekennzeichnet, daß bei Verwendung einer Doppelschicht aus Polysilizium (32) und Metallsilizid (33), vorzugsweise Tantalsilizid, nach Verfahrensschritt o) die Arsen-Ionenimplantation nach Verfahrensschritt p) vor der ganzflächigen Oxidabscheidung (34) erfolgt.

11. Verfahren nach mindestens einem der Ansprüche 3 bis 9, dadurch gekennzeichnet, daß bei Verwendung einer Doppelschicht aus Polysilizium (32) und Metallsilizid (33), vorzugsweise Tantalsilizid, nach Verfahrensschritt o) die Arsendotierung bei der Polysiliziumabscheidung (32) erfolgt, danach Metallsilizid (33) abgeschieden wird und dann die ganzflächige Oxidabscheidung (34) nach Verfahrensschritt p) erfolgt.

## Revendications

1. Circuit contenant des transistors bipolaires (A) de transistors MOS complémentaires (B, C) sur un substrat commun (1) et dans lequel des bandes d'émetteur (37) des transistors bipolaires (A) et les électrodes de grille (35, 36) des transistors MOS (B, C) sont formées par le matériau et sont constituées par une couche d'un siliciure d'un métal à point de fusion élevé tel que le tantale, le tungstène, le molybdène, le titane ou le platine, caractérisé par le fait que,

   a) la bande d'émetteur (37) et l'émetteur (38) sont disposés d'une manière auto-alignée par rapport à la bande de base (43),

   b) au moins la bande d'émetteur (37) est constituée par un siliciure dopé ou une couche double dopée formée d'un polysiliciure et d'un siliciure,

   c) ce collecteur est contenu, sous la forme d'une zone enterrée (3) dans le substrat (1), et

   d) la borne de collecteur (6) est réalisée avec une forme annulaire autour du transistor bipolaire (A).

2. Circuit intégré à semiconducteurs suivant la revendication 1, caractérisé par le fait que la borne d'émetteur (37) est dopée par le l'arsenic et est constituée par du siliciure de tantale (33) ou du polysilicium (32) et un siliciure de tantale (33).

3. Procédé pour fabriquer un circuit intégré à semiconducteurs contenant un transistor bipolaire (A) et des transistors MOS (B, C) suivant la revendication 1 et/ou 2, et selon lequel on met en oeuvre les étapes opératoires suivantes:

   a) fabrication des zones ensevelies (3) dopées du type n⁺ dans le substrat (1) dopé du type p, par implantation (5) d'ions réalisant un dopage du type n, après un masquage préalable (4) des autres zones,

   b) déposer une couche épitaxiale (7) dopée de type p, sur toute la surface,

   c) produire une couche double isolante s'étendant sur toute la surface et formée de l'oxyde de silicium (8) et du nitrure de silicium (9),

   d) déterminer les zones pour la borne de collecteurs la plus profonde, par implantation profonde (11) d'ions résistant au dopage de type n, après structuration préalable de la couche de nitrure de silicium (9) au moyen de la photolithographie (10),

   e) produire les cuvettes de type n (14) dans le substrat (1) au moyen d'une implantation (12) d'ions dopés de type n après élimination des structures de nitrure de silicium au-dessus des zones en forme de cuvettes de type n (14),

   f) faire pénétrer par diffusion les ions implantés, fournissant un dopage de type n, dans le substrat (1) et oxyder simultanément (15) la surface dans la zone des cuvettes de type n (14),

   g) mettre en oeuvre une implantation profonde (16) d'ions de bore pour fabriquer une région, éloignée de la surface, de la zone de canal (17) des transistors de type n (B) après élimination des structures de nitrure de silicium (9a), l'oxyde (15) agissant comme masque,

   h) déposer une couche double constituée par de l'oxyde de silicium (18) et du nitrure de silicium (19) et procurer de façon correspondante la couche de nitrure de silicium (19) pour l'oxydation locale (LOCOS) ultérieure,

   i) exécuter une implantation de bore (22) pour doper les zones d'oxyde de champ (23) des transistors à canal n après masquage préalable (21) des autres zones par une laque photosensible,

   j) fabrication de l'oxyde de champ nécessaire pour la séparation des régions actives des transistors (A, B, C) dans le substrat (1) par oxydation locale après suppression du masque (21) et par utilisation d'une structure de nitrure de silicium (19) comme masque d'oxydation,

   k) réaliser une excitation sur toute la surface pour produire l'oxyde de grille (25) après suppression des structures de nitrure de silicium (19),

   l) exécuter une implantation de bore sur une faible hauteur et dans toute la surface pour doper les zones de canal (26, 27) des transistors MOS à canal n et à canal p,

   m) fabriquer la zone de base (31) dans la région (A) du transistor bipolaire par implantation (29) d'ions de bore, après masquage préalable (30) des autres zones par une laque photosensible,

   n) éliminer l'oxyde de grille (25) dans la région de la zone de base (31),

   o) déposer, sur toute la surface, un silicium métallique (33) ou une couche double formée de polysilicium (32) et d'un silicium métallique (33),

   p) déposer une couche d'oxyde (34) sur toute la surface et appliquer une implantation d'ions d'arsenic,

   q) structurer la couche de siliciure métallique (33) ou la couche double la polyizide (32, 33) pour fabriquer les électrodes de grille (35, 36) des transistors MOS (B, C) et des bandes d'émetteur (37) des transistors bipolaires (A),

   r) appliquer un traitement haute température pour produire la zone d'émetteur (38),

   s) déposer, sur toute la surface, une couche d'oxyde de silicium (39) agissant en tant que couche intermédiaire, à partir de la phase gazeuse,

   t) fabriquer simultanément les zones de source/drain (40) des transistors à canal n (B) et du contact de collecteurs du type n⁺ (41) des transistors bipolaires (A) par implantation d'ions de phosphore après masquage préalable, par une laque photosensible, des régions (C) des transistors à canal p et des régions (A) des transistors bipolaires, à l'exception de la région de collecteurs de type n⁺ (41),

   u) fabriquer simultanément les régions de source/drain (42) des transistors (C) à canal p et du contact de base de type p⁺ (43) des transistors bipolaires (A) par implantation d'ions de bore, après un masquage antérieur (44), à l'aide d'une laque photosensible, des régions (B) des transistors à canal n et des régions (A) du transistor bipolaire, à l'exception de la zone de base de type p$^+$ (43),

v) retirer le masque de laque photosensible (44), libérer les zones des trous de contact, y faire passer la métallisation pour établir la liaison avec l'électrode de raccordement et une passivation.

4. Procédé suivant la revendication 3, caractérisé par le fait qu'entre des étapes opératoires k) et l), après la mise en oeuvre d'une technique photochimique, on réalisé une implantation d'ions de bore dans la zone des transistors MOS à canal n (B).

5. Procédé suivant les revendications 3 et 4, caractérisé par le fait qu'on utilise un substrat en silicium (1) dopé de type p possédant une orientation (100) et une résistance électrique spécifique de 20 ohm.cm.

6. Procédé suivant les revendications 3 et 4, caractérisé par le fait qu'on utilise un substrat en silicium (1) dopé de type p possédant une orientation (100) et une résistance électrique spécifique de 0,02 ohm.cm, et que l'étape opératoire a) est supprimée.

7. Procédé suivant au moins l'une les revendications 3 à 5, caractérisé par le fait que les étapes opératoires a) et b) sont supprimées.

8. Procédé suivant au moins l'une des revendications 3 à 7, caractérisé par le fait qu'on règle la résistance électrique spécifique de la couche épitaxiale (7) dopée du type p, après l'étape opératoire b) à la valeur de 20 ohm.cm et qu'on règle l'épaisseur de couche à une valeur de 3 µm.

9. Procédé suivant au moins l'une les revendications 3 à 8, caractérisé par le fait que la fabrication de la couche intermédiaire d'oxyde (39) selon l'étape opératoire s) est obtenue au moyen d'une dissociation thermique de l'orthosilicate de tétraéthyle (= TEOS).

10. Procédé suivant au moins l'une des revendications 3 à 9, caractérisé par le fait que dans le cas de l'utilisation d'une couche double de polysilicium (32) et d'un siliciure métallique (33), de préférence du siliciure de tantale, conformément à l'étape opératoire o), l'implantation d'ions d'arsenic conformément à l'étape p) s'effectue avant l'enlèvement (34) de l'oxyde sur toute la surface.

11. Procédé suivant au moins l'une des revendications 3 à 9, caractérisé par le fait que dans le cas de l'utilisation d'une couche double formée de polysilicium (32) et d'un siliciure métallique (33), de préférence du siliciure de tantale, après l'étape opératoire o), on met en oeuvre le dopage à l'arsenic lors du dépôt (32) du polysilicium, puis on déposé un siliciure métallique (33), et on réalise ensuite le dépôt (33) d'un oxyde sur toute la surface conformément à l'étape opératoire p).

**Claims**

1. Integrated circuit containing bipolar (A) and complementary MOS transistors (B, C) on a common substrate (1), in which circuit the emitter terminals (37) of the bipolar transistors (A) and the gate electrodes (35, 36) of the MOS transistors (B, C) consist of the same material and at least of a layer of a silicide of a metal with a high melting point, such as tantalum, tungsten, molybdenum, titanium or platinum, characterized in that

a) the emitter terminal (37) and the emitter (38) are arranged in a self-adjusting manner in respect of the base terminal (43),

b) at least the emitter terminal (37) consists of a doped silicide or of a doped double layer of polysilicon and silicide,

c) the collector is contained as a buried zone (3) in the substrate (1), and

d) the collector terminal (6) is of annular design around the bipolar transistor (A).

2. Integrated semiconductor circuit according to Claim 1, characterized in that the emitter terminal (37) is doped with arsenic and consists of tantalum silicide (33) or polysilicon (32) and tantalum silicide (33).

3. Method for manufacturing an integrated semiconductor circuit containing bipolar (A) and MOS transistors (B, C) according to Claim 1 and/ or 2, in which the following method steps occur:

a) manufacturing the buried n$^+$-doped zones (3) in the p-doped substrate (1) by implantation (5) of n-doped ions after previous masking (4) of the other regions,

b) applying a p-doped epitaxial layer (7) over the whole surface,

c) producing an insulating double layer of silicon oxide (8) and silicon nitride (9) over the whole surface,

d) determining the regions for the deeply extending collector terminal (6) by means of a deep implantation (11) with n-doped ions after previous structuring of the silicon nitride layer (9) by means of photolithography (10),

e) producing the n-wells (14) in the substrate (1) by implantation (1) of n-doped ions after removing the silicon nitride structures over the n-well regions (14),

f) diffusing the implanted, n-doped ions into the substrate (1) and simultaneous oxidation (15) of the surface in the n-well regions (14),

g) carrying out a deep implantation (16) of boron ions for the purpose of manufacturing a region, remote from the surface, of the channel zone (17) of the n-channel transistors (B) after removing the silicon nitride structures (9a), the oxide (15) acting as mask,

h) applying a double layer consisting of silicon oxide (18) and silicon nitride (19) and corresponding structuring of the silicon nitride layer (19) for the subsequent local oxidation (LOCOS),

i) carrying out a boron ion implantation (22) for the purpose of doping the field oxide regions (23) of the n-channel transistors after previous photoresist masking (21) of the other regions,

j) manufacturing the field oxide (24) required for separating the active transistor regions (A, B, C) in the substrate (1) by means of local oxidation after removal of the photoresist mask (21) and using the silicon nitride structure (19) as oxidation mask,

k) oxidation over the whole surface for the purpose of producing the gate oxide (25) after removal of the silicon nitride structures (19),

l) carrying out a planar boron implantation over the whole surface for the purpose of doping the channel regions (26, 27) of the n- and p-channel MOS transistors,

m) manufacturing the base zone (31) in the bipolar transistor region (a) by means of boron ion implantation (29) after previous photoresist masking (30) of the other regions,

n) removal of the gate oxide (25) in the region of the base zone (31),

o) deposition of metal silicide (33) over the whole surface or of a double layer of polysilicon (32) and metal silicide (33),

p) deposition of an oxide layer (34) over the whole surface and implantation of arsenic ions,

q) structuring of the metal silicide layer (33) or of the polysilicide double layer (32, 33) for the purpose of manufacturing the gate electrodes (35, 36) of the MOS transistors (B, C) and of the emitter terminals (37) of the bipolar transistors (A),

r) carrying out a high-temperature treatment for the purpose of producing the emitter zone (38),

s) deposition of a silicon oxide layer (39), acting as intermediate oxide, over the whole surface from the gas phase,

t) simultaneous manufacture of the source/drain regions (40) of the n-channel transistors (B) and of the $n^+$-collector contact (41) of the bipolar transistors (A) by means of phosphorus ion implantation after previous photoresist masking of the p-channel transistor regions (C) and of the bipolar transistor regions (A) with the exception of the $n^+$-collector region (41),

u) simultaneous manufacture of the source/drain regions (42) of the p-channel transistors (C) and of the $p^+$-base contact (43) of the bipolar transistors (A) by means of boron ion implantation after previous photoresist masking (44) of the n-channel transistor regions (B) and of the bipolar transistor regions (A) with the exception of the $p^+$-base region (43),

v) removal of the photoresist mask (44), exposure of the contact hole regions, carrying out the metallization for the purpose of manufacturing the terminal electrodes and passivation in a known manner.

4. Method according to Claim 3, characterized in that between method step k) and l), according to previous phototechnology, the implantation of boron ions in the region of the n-channel MOS transistors (B) is carried out.

5. Method according to Claim 3 and 4, characterized in that a p-doped, (100)-oriented silicon substrate (1) having a specific electrical resistance of 20 ohm cm is used.

6. Method according to Claim 3 and 4, characterized in that a p-doped, (100)-oriented silicon substrate (1) having a specific electrical resistance of 0.02 ohm cm is used, and in that the method step a) is omitted.

7. Method according to at least one of Claims 3 to 5, characterized in that the method steps a) and b) are omitted.

8. Method according to at least one of Claims 3 to 7, characterized in that the specific electrical resistance of the p-doped epitaxial layer (7) according to method step b) is set to 20 ohm cm and the layer thickness to approximately 3 μm.

9. Method according to at least one of Claims 3 to 8, characterized in that the manufacture of the intermediate oxide layer (39) according to method step s) occurs by means of thermal decomposition of tetraethyl orthosilicate (= TEOS).

10. Method according to at least one of Claims 3 to 9, characterized in that, when using a double layer of polysilicon (32) and metal silicide (33), preferably tantalum silicide, according to method step o), the implantation of arsenic ions according to method step p) occurs before the oxide deposition (34) over the whole surface.

11. Method according to at least one of Claims 3 to 9, characterized in that, when using a double layer of polysilicon (32) and metal silicide (33), preferably tantalum silicide, according to method step o), the arsenic doping occurs during the polysilicon deposition, and, after this, metal silicide (33) is deposited and then the oxide deposition (34) according to method step p) over the whole surface occurs.

# FIG 1

# FIG 2

# FIG 3

## FIG 4

## FIG 5

## FIG 6

2

## FIG 7

## FIG 8

## FIG 9

# FIG 10

# FIG 11

# FIG 12

A ——— B ——— C

4

# FIG 13

# FIG 14